Europäisches Patentamt

European Patent Office

Office européen des brevets

(11) Numéro de publication: **0 289 377**
**A1**

## (12) DEMANDE DE BREVET EUROPEEN

(21) Numéro de dépôt: **88400770.9**

(22) Date de dépôt: **30.03.88**

(51) Int. Cl.⁴: **G 01 R 31/26**

(30) Priorité: **03.04.87 FR 8704714**

(43) Date de publication de la demande:
**02.11.88 Bulletin 88/44**

(84) Etats contractants désignés: **DE GB IT NL**

(71) Demandeur: **COMMISSARIAT A L'ENERGIE ATOMIQUE**
**31/33, rue de la Fédération**
**F-75015 Paris (FR)**

(72) Inventeur: **Pupat, François**
**8, Hameau du Galion**
**F-91659 Breuillet (FR)**

(74) Mandataire: **Mongrédien, André et al**
**c/o BREVATOME 25, rue de Ponthieu**
**F-75008 Paris (FR)**

(54) **Dispositif de mesure en temps réel de la sensibilité et/ou de la linéarité d'un récepteur optique.**

(57) Dispositif de mesure de la sensibilité et/ou de la linéarité d'un récepteur optique.

Le dispositif comprend :

- un ensemble émetteur (10) comprenant un émetteur optique (17) et des moyens de commande électrique (11, 12, 14, 16) aptes à appliquer à cet émetteur un train d'impulsions électriques constitué par une alternance d'impulsions de faible amplitude et d'impulsions de forte amplitude ; le rapport entre la forte et la faible amplitude lumineuse est égal à une valeur R réglable ;

- un ensemble récepteur (20) comprenant une entrée de signal (21) apte à être reliée au récepteur optique (30) que l'on veut mesurer, deux commutateurs (22, 23) et deux voies (24, 25), l'une des voies étant réglée pour avoir une sensibilité faible et l'autre voie étant réglée pour avoir une sensibilité forte, le rapport entre la forte et la faible sensibilité étant égal audit rapport R.

- un oscilloscope (28) affichant les traces des deux signaux.
Application dans le contrôle des photorécepteurs.

FIG. 1

EP 0 289 377 A1

## Description

# DISPOSITIF DE MESURE EN TEMPS REEL DE LA SENSIBILITE ET/OU DE LA LINEARITE D'UN RECEPTEUR OPTIQUE

La présente invention a pour objet un dispositif de mesure en temps réel de la sensibilité et/ou de la linéarité d'un récepteur optique.

Elle trouve une application dans le contrôle des performances de photorécepteurs (photodiodes, photorésistances, phototransistors, etc...) en tant que tels ou en tant que composants de liaisons optiques. Son principe peut être étendu à la mesure d'autres éléments constitutifs des liaisons optiques ou autres (émetteurs, liaisons complètes, etc...).

Pour mesurer la sensibilité et la linéarité d'un récepteur optique, on applique à celui-ci un signal optique d'intensité croissante et l'on relève l'amplitude du signal électrique délivré. Si la courbe représentant les variations du signal électrique de sortie en fonction de l'intensité du rayonnement incident est une droite, le récepteur est linéaire et la pente de cette droite donne la sensibilité. Tout écart de la courbe par rapport à une droite traduit une non-linéarité du récepteur.

Bien que d'un usage courant en laboratoire, cette technique de mesure est cependant longue et ne permet pas de suivre en temps réel le comportement d'un récepteur, lorsque certains paramètres varient (optiques ou électriques).

La présente invention a justement pour but de remédier à ces inconvénients. A cette fin, elle propose un dispositif qui permet de visualiser immédiatement la sensibilité et l'éventuelle non linéarité d'un récepteur.

De façon précise, le dispositif de l'invention est caractérisé par le fait qu'il comprend :

- un ensemble émetteur comprenant un émetteur optique et des moyens de commande électrique aptes à appliquer à cet émetteur un train d'impulsions électriques constitué par une alternance d'impulsions de faible amplitude et d'impulsions de forte amplitude, le rapport entre la forte et la faible amplitude étant tel que le rapport des amplitudes lumineuses soit égal à une valeur R réglable,

- un ensemble récepteur comprenant une entrée de signal apte à être reliée au récepteur optique que l'on veut mesurer, deux commutateurs électriques permettant de faire transiter les signaux électriques délivrés par le récepteur alternativement par une voie de gain G et par une voie de gain GR et une sortie de signal, la synchronisation des voies étant réglée de telle sorte que le signal électrique correspondant à l'impulsion lumineuse de faible amplitude transite par la voie de plus fort gain GR et que le signal électrique correspondant à l'impulsion lumineuse de plus forte amplitude transite par la voie de plus faible gain G,

- un dispositif de visualisation où d'enregistrement des impulsions électriques, ce dispositif étant relié à la sortie du récepteur.

De toute façon, les caractéristiques de l'invention apparaîtront mieux après la description qui va suivre. Cette description se réfère à des dessins annexés sur lesquels :

- la figure 1 montre un mode de réalisation du dispositif de l'invention ;
- la figure 2 montre un exemple de traces obtenues avec un récepteur linéaire ;
- la figure 3 montre un exemple de traces obtenues avec un récepteur non linéaire.

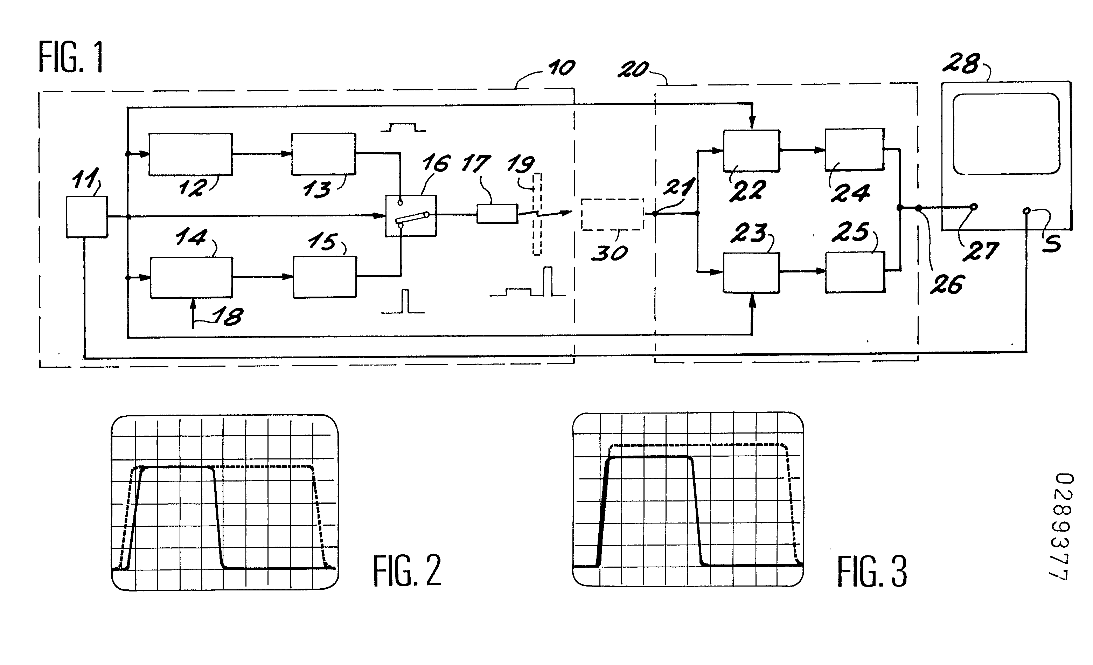

Le dispositif représenté sur la figure 1 comprend un ensemble émetteur 10 et un ensemble récepteur 20. Le récepteur à tester porte la référence 30.

Dans le mode de réalisation illustré, l'ensemble émetteur comprend une horloge 11, deux générateurs d'impulsions 12 et 14 commandés par l'horloge, l'un des générateurs 12 émettant des impulsions électriques ayant toutes une même amplitude, l'autre générateur 14 émettant des impulsions ayant une amplitude environ R fois plus grande ; l'ensemble émetteur comprend encore un commutateur 16 à deux entrées reliées aux deux générateurs 12, 14 et à une sortie reliée à un émetteur optique 17, ce commutateur étant commandé par l'horloge 11.

Ce dispositif peut comprendre en outre des circuits de compensation 13 et 15 pour tenir compte du comportement de l'émetteur 17, par exemple en fonction de la température.

En supposant que c'est le générateur 14 qui émet les impulsions de plus grande amplitude, celles-ci sont environ R fois plus grandes que les impulsions émises par le générateur 12.

Le fonctionnement de l'ensemble émetteur 10 est le suivant. Les générateurs 12 et 14 émettent leurs impulsions au rythme imposé par l'horloge 11. Le commutateur 16 bascule alternativement d'une position à l'autre à ce même rythme. L'émetteur 17 reçoit donc alternativement une impulsion de faible amplitude et une impulsion de forte amplitude. De préférence, ces impulsions ont des largeurs différentes pour une raison qui apparaîtra plus clairement par la suite.

Les impulsions lumineuses délivrées par l'émetteur 17, éventuellement atténuées par un filtre 19, sont donc alternativement de faible et de forte amplitude dans le rapport R. Un moyen 18 permet de régler R (potentiomètre, atténuateur, etc...). Ces impulsions sont dirigées sur le récepteur 30 dont on veut contrôler la sensibilité et la linéarité. Ce récepteur est connecté à l'ensemble récepteur 20 par une entrée de signal 21. L'ensemble récepteur 20 comprend deux commutateurs 22 et 23 commandés par l'horloge 11. Les commutateurs 22 et 23 autorisent les signaux électriques délivrés par le récepteur 30 à transiter alternativement par une voie de gain faible 24 et par une voie de gain fort 25, le rapport des gains étant justement égal au rapport R qui lie les intensités des signaux optiques reçus par le photorécepteur. Par ailleurs, la synchronisation des commutateurs est réglée de telle sorte que le signal électrique de plus faible amplitude transite par la voie de plus fort gain et que le signal électrique de plus forte amplitude transite par la voie de plus faible gain. La sortie 26 du récepteur est connectée à l'entrée 27 d'un oscilloscope 28 ; une entrée de synchronisation S reçoit les impulsions de l'horloge.

Le fonctionnement de l'ensemble récepteur est le suivant. Si le récepteur est parfaitement linéaire, il délivre des impulsions électriques dont les amplitudes sont dans le même rapport R que les amplitudes des impulsions lumineuses qu'il reçoit. Dans ces conditions, les impulsions visibles sur l'écran de l'oscilloscope ont même amplitude et viennent se confondre dans leur palier supérieur.

La différence de largeur entre les impulsions successives permet toutefois de distinguer les deux traces, la plus large correspondant, par exemple, aux impulsions de plus faible amplitude et à la voie de plus grande sensibilité.

La figure 2 montre les traces obtenues dans ce cas.

Si le récepteur n'est pas parfaitement linéaire, l'impulsion électrique de plus forte amplitude sera légèrement plus faible ou plus forte que dans le cas précédent. Les deux traces visibles sur l'écran de l'oscilloscope ne seront pas parfaitement confondues et la trace la plus étroite (qui, dans l'exemple illustré correspond aux impulsions de plus grande amplitude) sera légèrement en-dessous ou en-dessus de la trace la plus large. C'est ce qui est représenté sur la figure 3. L'écart entre les deux courbes donne directement la non linéarité du récepteur. Quant à la sensibilité, elle est donnée par l'amplitude des signaux affichés.

Naturellement on pourra remplacer l'ensemble 24, 25 et 28 par un oscilloscope à double trace.

Dans un mode de réalisation particulier, l'inventeur a utilisé des impulsions lumineuses dont les puissances étaient respectivement de 25 et 250 μW et les largeurs respectivement de 2 et 1 μs. La valeur de R était donc égale à 10. La gamme de réglage de R était de ±20%. La fréquence de récurrence de l'horloge était de 1 kHz.

## Revendications

1. Dispositif de mesure de la sensibilité et/ou de la linéarité d'un récepteur optique, caractérisé par le fait qu'il comprend :
- un ensemble émetteur (10) comprenant un émetteur optique (17) et des moyens de commande électrique (11, 12, 14, 16) aptes à appliquer à cet émetteur un train d'impulsions électriques constitué par une alternance d'impulsions de faible amplitude et d'impulsions de forte amplitude, le rapport entre la forte et la faible amplitude étant tel que le rapport des amplitudes lumineuses soit égal à une valeur R réglable,
- un ensemble récepteur (20) comprenant une entrée de signal apte à être reliée au récepteur optique (30) que l'on veut mesurer, deux commutateurs électriques permettant de faire transiter les signaux électriques délivrés par le récepteur (30) alternativement par une voie de gain G (24) et par une voie de gain GR (25) et une sortie de signal (26), la synchronisation des voies étant réglée de telle sorte que le signal électrique correspondant à l'impulsion lumineuse de faible amplitude transite par la voie de plus fort gain GR et que le signal électrique correspondant à l'impulsion lumineuse de plus forte amplitude transite par la voie de plus faible gain G,
- un dispositif de visualisation (28) ou d'enregistrement des impulsions électriques, dont l'entrée (27) est reliée à la sortie (26) du récepteur.

2. Dispositif selon la revendication 1, caractérisé par le fait que les moyens de commande électrique (11, 12, 14) de l'émetteur optique (17) délivrent des impulsions électriques dont la largeur passe alternativement d'une valeur faible à une valeur forte.

3. Dispositif selon la revendication 2, caractérisé par le fait que les moyens de commande électrique comprennent une horloge (11), deux générateurs d'impulsions (12, 14) commandés par l'horloge, l'un des générateurs (12) émettant des impulsions électriques ayant toutes une certaine durée et une certaine amplitude, l'autre générateur (14) émettant des impulsions ayant toutes une autre durée et une autre amplitude, un commutateur (16) à deux entrées reliées aux deux générateurs (12, 14) et à une sortie reliée à l'émetteur optique (17), le commutateur étant commandé par l'horloge (11).

4. Dispositif selon la revendication 1, caractérisé par le fait que les deux voies de gain différent et le moyen d'affichage sont constitués par un oscilloscope à double trace.

FIG. 1

FIG. 2

FIG. 3

0289377

Office européen
des brevets

**RAPPORT DE RECHERCHE EUROPEENNE**

Numero de la demande

EP 88 40 0770

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-3 919 639 (LICENTIA)<br>* Résumé; figure 1 *<br>--- | 1 | G 01 R 31/26 |
| Y | FR-A-2 056 316 (GEN. INSTRUMENT)<br>* Figure 5; page 15, ligne 34 - page 16, ligne 24; page 21, revendication 1 *<br>--- | 1 | |
| A | US-A-4 144 488 (U.S.A.)<br>----- | | |

| | |
|---|---|
| | **DOMAINES TECHNIQUES RECHERCHES (Int. Cl.4)**<br><br>G 01 R |

Le présent rapport a été établi pour toutes les revendications

| Lieu de la recherche | Date d'achèvement de la recherche | Examinateur |
|---|---|---|
| LA HAYE | 11-08-1988 | HOORNAERT W. |